(19) 

**Europäisches Patentamt**
**European Patent Office**
**Office européen des brevets**

(11) **EP 4 757 168 A1**

(12) **EUROPEAN PATENT APPLICATION**
published in accordance with Art. 153(4) EPC

(43) Date of publication:
**10.06.2026 Bulletin 2026/24**

(21) Application number: **23951149.6**

(22) Date of filing: **06.09.2023**

(51) International Patent Classification (IPC):
**H02P 21/18** (2016.01)

(52) Cooperative Patent Classification (CPC):
**H02P 21/18**

(86) International application number:
**PCT/CN2023/117324**

(87) International publication number:
**WO 2025/050322 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Johnson Electric International AG
3280 Murten (CH)**

(72) Inventors:
• **HONG, Xiaoyuan
  Shenzhen, Guangdong 518125 (CN)**

• **LI, Yanmei
  Shenzhen, Guangdong 518125 (CN)**
• **WANG, Xiaoming
  Shenzhen, Guangdong 518125 (CN)**
• **HUANG, Zongchun
  Shenzhen, Guangdong 518125 (CN)**
• **YIN, Jianfeng
  Shenzhen, Guangdong 518125 (CN)**
• **TONG, Gaoqiang
  Shenzhen, Guangdong 518125 (CN)**

(74) Representative: **Doherty, William et al
Albright IP Limited
County House
Bayshill Road
Cheltenham, Glos. GL50 3BA (GB)**

(54) **METHOD AND APPARATUS FOR DETECTING ANGLE POSITION OF ROTOR OF ELECTRIC MOTOR, AND COLD START METHOD**

(57)     The present disclosure provides a method for detecting an angle position of a rotor, comprising: obtaining a single sinusoidal signal by detecting a voltage waveform outputted by a hall sensor; obtaining a first cosine signal according to the signal; converting the signal sinusoidal signal into a square wave signal to control a PI module of a phase locked loop module to be enabled or to be disabled; estimating an estimation value of the angular velocity signal in real time during the PI module being enable; obtaining an estimation value of the angle postion according to the angular velocity signal, thus to obtain a second cosine signal and obtain a positive or negative sign of the magnitude of the waveform; obtaining a cosine signal, based on the first cosine signal and the positive or negative sign; obtaining an error signal of the angle position configured for the PI module to estimate the angular velocity signal, based on the single sinusoidal signal, the cosine signal, and the estimation value of the angle position; and performing a difference operation between the error signal of the angle position and an error set value of the angle, and outputting the estimation value of the angle position to be an actual value of the angle position when the phase locked loop module judges that a result of the difference operation converges. The present disclosure is inexpensive, and have a high accuracy.

FIG. 5

**Description**

TECHNICAL FIELD

The present disclosure relates to a motor control technology, and more particularly to a method for detecting an angle position of a rotor of an electric motor, a device for detecting an angle position of a rotor of an electric motor, and a cold start method.

BACKGROUND

Permanent magnet synchronous motor (PMSM) has widely used in fields of aerospaces, industrial arts, electric cars, household applications, etc due to their higher reliability and smaller size compared to other types of electric motors. To ensure that the permanent magnet synchronous motor to stably and reliably operate, it need to detect a position of a rotor of the PMSM. An accuracy of an angle of the rotor of the electric motor plays an important role in a performance of a motor control. When a detection of the angle of the rotor is inaccurate, disadvantage such as a reduction of a control efficiency of the PMSM, a serious heat emission from the PMSM, and a large noise may be caused.

To detect the position of the rotor of the PMSM, a number of hall sensors or a rotary transformer, also known as a resolver, is usually installed on the PMSM. For example, by combining the hall sensors to detect the position of the rotor, the hall sensors are installed on different positions of the electric motor to detect, to ensure an accurate detection of the position of the rotor, however, the installation of the hall sensors may bring problems of an increase in the cost of the system, an increase in the size, and a reducing in the reliability, and may limit an application occasions of the PMSM. An accuracy of the detection of the rotary transformer is higher, by combining the rotary transformer and the decoding chip to detect the position of the rotor of the PMSM, first an decoding operation is performed on an output signal indicating the angle of a rotor of the rotary transformer by the decoding chip, to obtain the angle of the rotor of the rotary transformer, and then the angle of the rotor of the PMSM is determined according to the angle of the rotor of the rotary transformer, thus the position of the rotor of the PMSM is determined. However, because a cost of the decoding chip is higher, thus a detection of the position of the rotor of the PMSM by the rotary transformer has disadvantages of a larger size, a higher expense, and so on.

Technical problem needed to be resolved urgently by the skilled person in the art are how to seek a method for detecting the angle of the rotor of the electric motor and a device for detecting the angle of the rotor of the electric motor with a low cost, and can achieve a high accuracy detection of the angle of the rotor of the electric motor.

SUMMARY

In view of the above problems, the present disclosure provides a method for detecting an angle position of a rotor of an electric motor, a device for detecting an angle position of a rotor of an electric motor, and a related cold start method, to resolve the problems.

According to an embodiment of the present disclosure, there is provided a method for detecting an angle position of a rotor of an electric motor, including: sensing a position of the rotor by a hall sensor, outputting a voltage waveform signal, and performing a normalization processing on the voltage waveform signal to obtain a single sinusoidal signal $sin\,\theta$; obtaining a first cosine signal $\sqrt{1 - sin\,\theta^2}$ according to the single sinusoidal signal $sin\,\theta$; converting the signal sinusoidal signal $sin\,\theta$ into a square wave signal to control a proportional integral module of a phase locked loop module to be enabled or to be disabled, by identifying a pluralty of peak sections and a plurality of valley sections of the single sinusoidal signal $sin\,\theta$; estimating, during the proportional integral control module being enable, an estimation value of an angular velocity signal $\hat{\omega}_k = K_p * sin(\theta_k - \hat{\theta}_{k-1}) + K_i * T_s * \int sin(\theta_k - \hat{\theta}_{k-1})$ by the proportional integral control module in real time, where, $K_p$ is a proportional gain, $K_i$ is an integral gain, and $T_s$ is a sampled time; obtaining an estimation value $\hat{\theta}$ of the angle postion according to the angular velocity signal $\hat{\omega}_k$ of the rotor; obtaining a second cosine signal $cos\,\hat{\theta}$ and obtaining a positive or negative sign of a magnitude of a waveform of the second cosine signal $cos\,\hat{\theta}$, based on the estimation value $\hat{\theta}$ of the angle position; obtaining a cosine signal $cos\,\theta$, based on the first cosine signal $\sqrt{1 - sin\,\theta^2}$ and the positive or negative sign; obtaining an error signal $\theta_{err}$ of the angle position configured for the proportional integral control module to estimate the angular velocity signal $\hat{\omega}_k$, based on the single sinusoidal signal $sin\,\theta$, the cosine signal $cos\,\theta$, and the estimation value $\hat{\theta}$ of the angle position; and performing a difference operation between the error signal $\theta_{err}$ of the angle position and an error set value of an angle to obtain $sin(\theta_k - \hat{\theta}_{k-1})$, and outputting the estimation value $\hat{\theta}$ of the angle position to be an actual value $\theta$ of the angle position when the phase locked loop module judges that $sin(\theta_k - \hat{\theta}_{k-1})$ converges to $\theta_k - \hat{\theta}_{k-1}$.

Preferably, the converting the signal sinusoidal signal $sin\,\theta$ to the square wave signal includes: converting, when the single sinusoidal signal *sin θ* is detected to be a peak, a waveform of each peak section of the plurality of peak sections from a front of the peak where the magnitude is greater than a first threshold to a back of the peak where the magnitude is greater than a second threshold into a low level; converting, when the single sinusoidal signal *sin θ* is detected to be a valley, a waveform of each valley section of the plurality of valley sections from a front of the valley where the magnitude is less than a third threshold to a back of the valley where the magnitude is less than a fourth threshold into the low level; and converting waveforms at the other sections of the signal sinusoidal signal *sin θ* into a high level; where, the first threshold and the second threshold are positive numbers, and the third threshold and the fourth threshold are negative numbers.

Preferably, the first threshold is 0.86 of a peak value of the single sinusoidal signal *sin θ*, the second threshold is 0.8 of the peak value of the single sinusoidal signal *sin θ*, the third threshold is -0.86 of the peak value of the single sinusoidal signal *sin θ*, and the fourth threshold is -0.8 of the peak value of the single sinusoidal signal *sin θ*.

Preferably, the proportional integral control module is controlled to be enabled or to be disabled, according to the square wave signal including: when the square wave signal is a high level, the proportional integral control module is enabled; and when the square wave signal is a low level, the proportional integral control module is disabled.

Preferably, the obtaining the estimation value $\hat{\theta}$ of the angle postion includes: using, during the proportional integral control module being disable, an estimate value $\hat{\omega}_{k,last}$ of the angular velocity signal at the moment before being disabled to be the estamition value $\hat{\omega}_k$ of the angular velocity signal during being disable.

Preferably, based on the estimation value $\hat{\omega}_k$ of the angular velocity signal, the estimation value $\hat{\theta}_k = T_s * \hat{\omega}_k + \hat{\theta}_{k-1}$ of the angle postion is obtained.

Preferably, the method for detecting the angle position of the rotor of the electric motor further includes: outputting a certain driving voltage and a certain angle of the rotor by a V/F drive-controlling, and starting the electric motor; starting the phase locked loop module, when the single sinusoidal signal *sin θ* of the electric motor is within a rising rangeof the waveform and the magnitude reaches a fifth threshold, or is within a descending range of the waveform and the magnitude reaches a sixth threshold; where the fifth threshold is a negative number, and the sixth threshold is a positive number..

Preferably, the fifth threshold is -1/2, and the sixth threshold is 1/2.

Preferably, the method for detecting the angle position of the rotor of the electric motor further includes: outputting the estimation value $\hat{\theta}$ of the angle position to a field-oriented control FOC module.

Preferably, the error signal $\theta_{err}(k)$ of the angle position corresponds to $sin(\hat{\theta}_{k-1} - \theta_k)$.

According to another embodiment of the present disclosure, there is provided a device for detecting an angle position of a rotor of an electric motor, including a detection module, a peak and valley identification module, and an improved phase locked loop module. The detection module is configured to sense a position of the rotor by a hall sensor, output a voltage waveform signal, and perform a normalization processing on the voltage waveform signal to obtain a single sinusoidal signal *sin θ*. The peak and valley identification module is configured to identify a plurality of peak sections and a plurality of valley sections of the single sinusoidal signal *sin θ*, and convert the signal sinusoidal signal *sin θ* into a square wave signal to enable or disable a proportional integral control module of a phase locked loop module. The phase locked loop module, including: a processing module configured to obtain a first cosine signal $\sqrt{1 - sin\,\theta^2}$ according to the single sinusoidal signal *sin θ*, and obtain a cosine signal *cosθ* based on the first cosine signal $\sqrt{1 - sin\,\theta^2}$ and a positive or negative sign of a magnitude of a waveform of a second cosine signal $cos\,\hat{\theta}$; the proportional integral control module configured to estimate, during being enable, an estimation value of an angular velocity signal $\hat{\omega}_k = K_p * sin(\theta_k - \theta_{k-1}) + K_i * T_s * \int sin(\theta_k - \theta_{k-1})$ in real time, and obtain an estimation value $\hat{\theta}$ of the angle postion according to the angular velocity signal $\hat{\omega}_k$ of the rotor, where $K_p$ is a proportional gain, $K_i$ is an integral gain, and $T_s$ is a sampled time; a sign function module configured to obtain the second cosine signal $cos\,\hat{\theta}$ and obtain the positive or negative sign of the magnitude of the waveform of the second cosine signal $cos\,\hat{\theta}$, based on the estimation value $\hat{\theta}$; and a difference operation module configured to perform a difference operation between an error signal $\theta_{err}$ of the angle position and an error set value of an angle to obtain $sin(\theta_k - \hat{\theta}_{k-1})$, and output the estimation value $\hat{\theta}$ of the angle position to be an actual value $\theta$ of the angle position when the phase locked loop module judges that $sin(\theta_k - \hat{\theta}_{k-1})$ converges to $\theta_k - \hat{\theta}_{k-1}$, where, the phase locked loop module further obtains an error signal $\theta_{err}$ of the angle position configured to estimate the angular velocity signal $\hat{\omega}_k$, based on the single sinusoidal signal *sin θ*, the cosine signal *cos θ*, and the estimation value $\hat{\theta}$ of the angle position.

Preferably, the peak and valley identification module converts, when the single sinusoidal signal *sin θ* is detected to be a peak, a waveform of each peak section of the plurality peak sections from a front of the peak where the magnitude is greater than a first threshold to a back of the peak where the magnitude is greater than a second threshold into a low level; converts, when the single sinusoidal signal *sin θ* is detected to be a valley, a waveform of each valley section of the plurality of valley sections from a front of the valley where the magnitude is less than a third threshold to a back of the valley where the magnitude is less than a fourth threshold into the low level; and converts waveforms at the other sections of the signal sinusoidal signal *sin θ* into a high level; where, the first threshold and the second threshold are positive numbers, and the third threshold and the fourth threshold are negative numbers.

Preferably, the first threshold T11 is 0.86 of a peak value of the single sinusoidal signal *sin θ*, the second threshold T12 is 0.8 of the peak value of the single sinusoidal signal *sin θ*, the third threshold T21 is -0.86 of the peak value of the single sinusoidal signal *sin θ*, and the fourth threshold T22 is -0.8 of the peak value of the single sinusoidal signal *sin θ*.

Preferably, the proportional integral control module is enabled when the square wave signal is a high level; and the proportional integral control module is disabled when the square wave signal is a low level.

Preferably, during the proportional integral control module being disable, an estimate value $\hat{\omega}_{k,last}$ of the angular velocity signal at the moment before being disabled is used to be the estamition value $\hat{\omega}_k$ of the angular velocity signal during being disable.

Preferably, based on the estimation value $\hat{\omega}_k$ of the angular velocity signal, the estimation value $\hat{\theta}_k = T_s * \hat{\omega}_k + \hat{\theta}_{k-1}$ of the angle postion is obtained.

Preferably, the device for detecting an angle position of a rotor of an electri motor further includes: a V/F driving module configured to output a certain driving voltage and a certain angle of the rotor, start the electric motor, and start the phase locked loop module when the single sinusoidal signal *sin θ* of the electric motor is within a rising range of the waveform and the magnitude reaches a fifth threshold, or is within a descending range of the waveform and the magnitude reaches a sixth threshold; where the fifth threshold is a negative number, and the sixth threshold is a positive number.

Preferably, the fifth threshold is -1/2, and the sixth threshold is 1/2.

Preferably, a device for detecting an angle position of a rotor of an electric motor further includes: a field-oriented control FOC module configured to call the estimation value $\hat{\theta}$ of the angle position outputted by the phase locked loop module, and drive the electic motor to work at a rotation speed value of a specified operting point.

Preferably, the error signal $\theta_{err}(k)$ of the angle position corresponds to $sin(\hat{\theta}_{k-1} - \theta_k)$.

According to another embodiment of the present disclosure, there is provided a cold start method of an electric motor, including: outputting a certain driving voltage and a certain angle of a rotor by a V/F driving controlling, and starting the electric motor; starting a phase locked loop module when the single sinusoidal signal *sin θ* of the electric motor is within a rising range of a waveform and a magnitude reaches a fifth threshold, or is within a descending range of the waveform and the magnitude reaches a sixth threshold, where the fifth threshold is a negative number, and the sixth threshold is a positive number; detecting an angle postion of the rotor, according to a method for detecting an angle position of the rotor of the electric motor of any one; and switching to a field-oriented control FOC closed-loop control, when the electric motor reaches a predetermined rotation speed value; where the field-oriented control FOC closed-loop control calls an estimation value of the angle postion, and drives the electric motor to reach a rotation speed value at a predetermined operating point.

Preferably, the phase locked loop module is started when any of the following condition is met: the fifth threshold is -1/2, and the sixth threshold is 1/2.

According to an embodiment of the present disclosure, the detecting of the angle of the motor of the electric motor is inexpensive, is simple and convenient operation, has a high extimation accuracy, and improves a reliability of a system.

DESCRIPTION OF THE DRAWINGS

In order to illustrate the technical solutions in the embodiments of the present disclosure or the existing arts more clearly, the drawings needed to be used in the description of the embodiments or the existing arts will be briefly described in the following, it is obvious that the drawings described below are only related to some embodiments of the present disclosure, for one ordinary skilled person in the art, other drawings can be obtained according to these providing drawings without making other inventive work.

FIG. 1 is a flowchart showing a method 100 for detecting an angle position of a rotor of an electric motor according to an embodiment of the present disclosure.

FIG. 2 is a waveform diagram of a sinusoidal signal and a square wave signal according to an embodiment of the present disclosure.

FIG. 3 is an exemplary structure of a device 300 for detecting an angle position of a rotor of an electric motor according to another embodiment of the present disclosure.

FIG. 4 is a diagram showing turning on a PLL strategy during a rising range according to an embodiment of the present disclosure.

FIG. 5 is a diagram showing a core module of an improved phase locked loop loop according to an embodiment of the present disclosure.

FIG. 6 is a view showing a cold start method 600 of an electric motor according to another embodiment of the present disclosure.

FIG. 7 is results of test runs of various parameter by a detecting of an angle position of an electric rotor according to an embodiment of the present disclosure.

FIG. 8 is a result of a test run of a three-phases current of an electric motor according to an embodiment of the present disclosure.

FIG. 9 is a result of a test run of a three-phases current of an electric motor according to another embodiment of the present disclosure.

DETAILED DESCRIPTION OF THE EMBODIMENTS

The technical solutions in the embodiments of the present disclosure will be described clearly and fully below with reference to the drawings in the embodiments of the disclosure. Evidently, the described embodiments are merely a part but not all of the embodiments of the present disclosure. Based upon the embodiments of the present disclosure, any other embodiments which will occur to those ordinarily skilled in the art without any inventive effort shall fall into the scope of protection of the present disclosure.

The schematic embodiments of the present disclosure and the explanations thereto are used for explaining the present disclosure, and shall not be deemed as the limit to the present disclosure. In addition, the elements/members with the same or similar numbers are used in the drawings and implementation manners to represent the same or similar parts.

The term "including", "comprising", "possessing", "containing", or the like, as used herein, is open term, namely including but not being limited to.

The term "and/or" as used herein includes any one or all combinations of things.

It is to be further noted that, as used herein, terms such as first and second, or the like may be used to distinguish one element from another element, without necessarily requiring or implying any actual such relationship or order between the elements. And, the terms "comprising", "including", or any other variation thereof are intended to mean a non-exclusive inclusion, such that an article or a device that comprises a list of elements does not include those elements solely, but may well include other elements not listed, or may include other elements inherent to such article, or device. Without more limitations, an element defined by the statement "including a ..." shall not be precluded to include additional same elements present in an article or a device including the elements.

During detecting an angle of an electric motor, a $cos\,\theta$ of a conventional phase locked loop is directly generated by the hall sensors, namely two paths of signal including a sinusoidal $sin\,\theta$ and a cosine $cos\,\theta$ are simultaneously provided by the hall sensors, however a method for detecting the angle of a rotor of the electric motor provided by the present disclosure only require a signal path of $sin\,\theta$ provided by the hall sensor, then obtain a magnitude of the cosine signal $cos\,\theta$ by a calculation of $\sqrt{1 - sin\,\theta^2}$, where a value of the calculation is always a positive value, thus to obtain a positive or negative sign of the magnitude of the cosine signal $cos\,\theta$ by an estimated angle position of the rotor, and finaly obtain a correct waveform of the cosine signal $cos\,\theta$.

According to a method and a device for detecting the angle position of the rotor of the electric mtor, and a cold start method, an improved phase locked loop (PLL) structure is employed to combine with a linear hall sensor to detect the angle position of the rotor of the electric motor, which can obtain a value of an angle detection of a range from 0 degrees to 360 degrees of the rotor of a three-phase electric motor only via a single path signal which is the single sinusoidal signal, and the detection accuracy is high. Otherwise, because only one hall sensor is employed, a cost of the electric motor and a size of the electric motor both decreases, and simultaneously the method for detecting of the embodiment of the present disclosure does not significantly increase a complexity in realization with software, and provides a positive assurance for an efficient and stable control of the system.

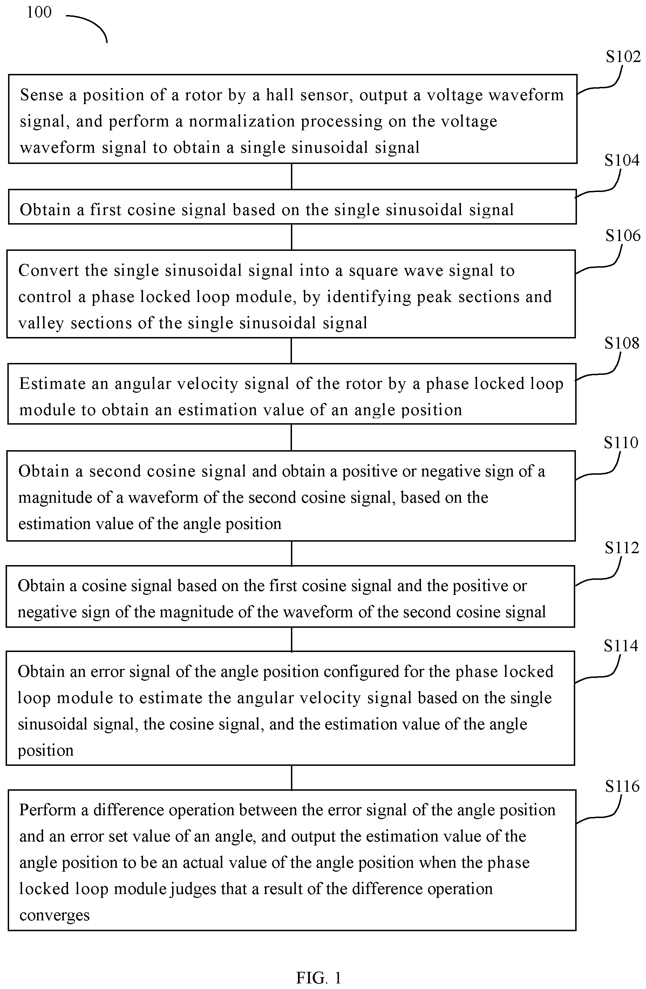

FIG. 1 is a flowchart showing the method 100 for detecting the angle position of the rotor of the electric motor according to an embodiment of the present disclosure. In some embodiments, one hall sensor (for example, single linear hall sensor) is installed on a printed circuit board assembly (PCBA) of a controller of a three-phases electric motor to detect the angle position of the rotor. The hall sensor is directly above the rotor of the electric motor, and is configured to sense a strength of the field of magnetic disks arranged on a top end of the rotor and outpout a sinusoidal voltage waveform signal, and the magnitude of the waveform of the outputted sinusoidal signal is a waveform varied with a supply voltage. The method includes the following steps:

S102: sensing a position of the rotor by the hall sensor, outputting a voltage waveform signal, and performing a normalization processing on the voltage waveform signal to obtain a single sinusoidal signal $sin\,\theta$. After the normalization processing, a range of a magnitude of the sinusoidal signal $sin\,\theta$ is from -1 to 1.

S104: obtaining a first cosine signal $\sqrt{1 - sin\,\theta^2}$, based on the single sinusoidal signal $sin\,\theta$.

S106: converting the single sinusoidal signal $sin\,\theta$ into a square wave signal to control an improved phase locked loop module (hereinafter PLL module) to be enabled or to be disabled, by identifying a number of peak sections and a number of valley sections of the single sinusoidal signal $sin\,\theta$. In detail, a proportional integral (PI) module in the PLL module is controlled to be enabled or disabled according to the square wave signal, for example, when the square wave signal is a a high evel, the proportional integral control module is enabled; and when the square wave signal is a low level, the proportional integral control module is disabled, thus to control the proportional integral control module of the PLL module to be enabled or to be disabled can be achieved by the square wave signal including the high level and the low level, and this is cyclically executed.

In some preferred embodiments, a real-time identification is performed on the magnitude of the waveform of the single sinusoidal signal $sin\,\theta$ from the normalization, and the magnitude of the waveform is compared with at least one threshold, when the waveform is detected to be about to near the peak and is greater than a set magnitude threshold T1 configured for disabling the PLL module (for example disabling the proportional integral control module), or when the waveform is detected to be about to near the valley and less than a set magnitude threshold T2 configured for disabling the PLL module (for example disabling the proportional integral control module), a low level is outputted, and the proportional integral control module is disabled. When the peak is passed and a real-time value of $sin\,\theta$ from the normalization is less than the set magnitude threshold T1 configured for disabling the proportional integral control module, or when the valley is passed and the real-time value of $sin\,\theta$ from the normalization is greater than the set magnitude threshold T2 configured for disabling the proportional integral control module, a high level is outputted, and the proportional integral control module is enabled.

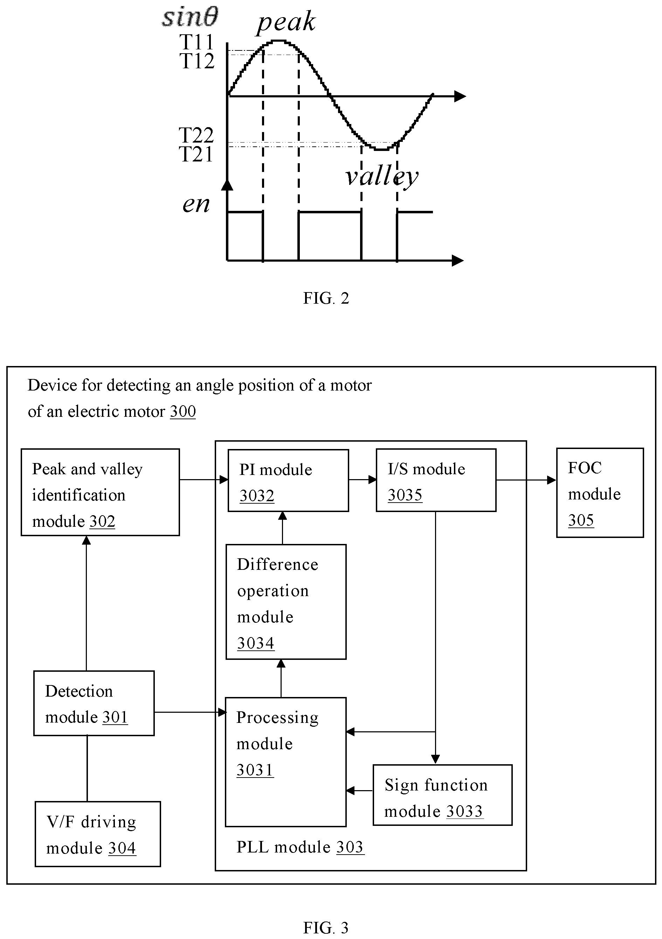

During cutting out a peak and valley region, a threshold hysteresis loop strategy is employed to set the threshold, thus T1 and T2 respectively includes two detail thresholds, T11 and T12, and T21 and T22. FIG. 2 is a waveform diagram of the sinusoidal signal and the square wave signal according to an embodiment of the present disclosure, as shown in FIG. 2, the sinusoidal signal $sin\,\theta$ is converted into the square wave signal en, where a first threshold T11 is positioned at a front of the peak of the sinusoidal signal $sin\,\theta$, a second threshold T12 is positioned in back of the peak of the sinusoidal signal $sin\,\theta$, a third threshold T21 is positioned at a front of the valley of the sinusoidal signal $sin\,\theta$, and a fourth threshold T22 is positioned in back of the valley of the sinusoidal signal $sin\,\theta$. When the single sinusoidal signal $sin\,\theta$ is detected to be the peak, a waveform of each peak section from a front of the peak where the magnitude is greater than the first threshold T11 to a back of peak where the magnitude is greater than the second threshold T12 is converted into the low level. When the single sinusoidal signal $sin\,\theta$ is detected to be the vallley, a waveform of a valley section from a front of the valley where the magnitude is less than the third threshold T21 to a back of the valley where the magnitude is less than the fourth threshold T22 is converted into the low level. And, waveforms at the other sections of the single sinusoidal signal $sin\,\theta$ are both coverted into the high level. In the embodiment, the first threshold T11 and the second threshold T21 are positive numbers, and the third threshold T21 and the fourth threshold T22 are negative numbers.

Preferably, the first threshold T11 can be set to be 0.86 of the peak value of the single sinusoidal signal $sin\,\theta$, the second threshold T12 can be set to be 0.8 of the peak value of the single sinusoidal signal $sin\,\theta$, the third threshold T21 can be set to be - 0.86 of the peak value of the single sinusoidal signal $sin\,\theta$, and the fourth theshold can be set to be -0.8 of the peak value of the single sinusoidal signal $sin\,\theta$. The set thresholds of the embodiment are not as a limit of the disclosure, enlarging or reducing the peaks sections and valley sections to be cut out by changing the thresholds are also feasible.

S108: estimating, during the proportional integral control module being enable, an estimation value $\hat{\omega}_k$ of an angular velocity signal in real time by the proportional integral control module, and then obtaining an estimation value $\hat{\theta}$ of the angle position according to the angular velocity signal $\hat{\omega}_k$ of the rotor. This step can be executed by the proportional integral control module to obtain the angular velocity signal $\hat{\omega}_k$, and then can calculate the estimation value $\hat{\theta}$ of the angle position according to the angular velocity signal $\hat{\omega}_k$ by an angle integration module (I/S module). Due to the nature of an electric motor system, after the PI session, an outputted physical quantity is the anglular velocity signal of the electric motor, namely $\hat{\omega}_k$. A calculation formula of $\hat{\omega}_k$ can be:

$$\widehat{\omega}_k = \sin(\theta - \hat{\theta}) * (K_p + Ki/s)$$

Discretization formulas of it is:

$$\widehat{\omega}_k = K_p * sin(\theta - \hat{\theta}) + K_i * T_s * \int sin(\theta - \hat{\theta})$$

Where, $K_p$ is a proportional gain, $K_i$ is an integral gain, $T_s$ is a sampled time, and $Ki/s$ is an accumulated sum of an integral error.

In some embodiments, during the proportional integral control module being enable, the estimation value of the angular velocity signal is estimated by the proportional integral control module in real time:

$$\widehat{\omega}_k = K_p * sin(\theta_k - \hat{\theta}_{k-1}) + K_i * T_s * \int sin(\theta_k - \hat{\theta}_{k-1})$$

During the proportional integral control module being disable, an estimation value $\hat{\omega}_{k,last}$ of the angular velocity signal at the moment before it is disabled is used to be the estimation value $\hat{\omega}_k$ of the angular velocity signal during being disable, namely during disabling the proportional integral control module, an integration over time is performed on the latest $\hat{\omega}_k$ (namely the estimation value $\hat{\omega}_{k,last}$ of the angular velocity signal obtained at the moment before the proportional integral control module is disabled) calculated by the proportional integral control module, to obtain the estimation value $\hat{\theta}$ of the angle position of the rotor of the electric motor: $\hat{\theta} = \hat{\omega}_{k,last} * T_s$.

According to the improved PLL module of the embodiment of the present disclosure, the estimation value of the angle position can be obtained based on the estimation value $\hat{\omega}_k$ of the angular velocity signal: $\hat{\theta}_k = T_s * \hat{\omega}_k + \hat{\theta}_{k-1}$.

The reason for disabling the PLL module at the peak sections and the valley sections is two folds: 1) because the positive or negative sign of the cosine signal $cos\,\theta$ is switched at the peak or valley of the sinusoidal signal $sin\,\theta$, if the PLL module is not disabled herein, the value of $cos\,\theta$ will indefinitely approach zero at the peak and at the valley, but never actually converge to zero, and the switching of the sign between the positive and the negative can not be achieved; 2) at the position of the valley of $sin\theta$, a slope is smaller, and the waveform is relatively gentle, a deviation of the magnitudes corresponding to different angles is small, and the effects of the nosie of an A/D sampling is added, causing the angle obtained herein to be inaccuracy, and a great deviate to be existed, thus the PLL module is disabled herein, for example the proportional integral control module is disabled. Due to inherent intertial properties of the electric motor, using the angular velocity (namely $\hat{\omega}_{k,last}$) obtained at the moment before the proportional integral control module is disabled to the angular velocity during disabling the proportional integral control module complies with mechanical characteristics.

In other words, $\hat{\omega}_k$ is equivalent to be a fixed value during disabling the proportional integral control module, and is equal to the estimation value $\hat{\omega}_{k,last}$ of the angular velocity obtained at the moment before the proportional integral control module is diabled, then a calculation at a first beat after enabling the proportional integral control module, still uses the fixed value $\hat{\omega}_{k,last}$ to calculate, and an output at a second beat is a new estimation value of the angular velocity, and during enabling the proportional integral control module, the estimation of the angle position $\hat{\theta}$ is obtained by a real-time integration of the estimation value of the angular velocity, the processing manner can effectively avoid the generated magnitude jumping seriously or overshooting during enabling the proportional integral control module.

S110: obtaining a second cosine signal $cos\,\hat{\theta}$ and obtaining a positive or negative sign of the magnitude of the waveform of the second cosine signal $cos\,\hat{\theta}$, based on the estimation value $\hat{\theta}$ of the angle position.

S112: obtaining a cosine signal $cos\,\theta$ based on the first cosine signal $\sqrt{1 - sin\,\theta^2}$ and the positive or negative sign of the magnitude of the waveform of the second cosine signal $cos\,\hat{\theta}$.

S114: obtaining an error signal $\theta_{err}$ of the angle position configured for the proportional integral control module to estimate the angular velocity signal $\hat{\omega}_k$ based on the single sinusoidal signal $sin\,\theta$, the cosine signal $cos\,\theta$, and the estimation value $\hat{\theta}$ of the angle position.

In some embodiments, the error signal $\theta_{err}$ of the angle position corresponds to $sin(\hat{\theta} - \theta)$, and the error signal $\theta_{err}$ of the angle position can be calculated by the following formula:

$$\theta_{err} \approx sin(\hat{\theta}_{k-1} - \theta_k) = sin\,\hat{\theta}_{k-1}\,cos\,\theta_k - cos\,\hat{\theta}_{k-1}\,sin\,\theta_k$$

Where, $\theta_k$ is an actual value of the angle position at a kth sampling moment, $\hat{\theta}_{k-1}$ is an estimation value of the angle position a a (k-1)th sampling moment.

S116: performing a difference operation between the error signal $\theta_{err}$ of the angle position and an error set value of the angle to obtain $sin(\theta_k - \hat{\theta}_{k-1})$, and outputting the estimation value $\hat{\theta}$ of the angle position to be an actual value $\theta$ of the angle position when the PLL module judges that $sin(\theta_k - \hat{\theta}_{k-1})$ converges to $\theta_k - \hat{\theta}_{k-1}$.

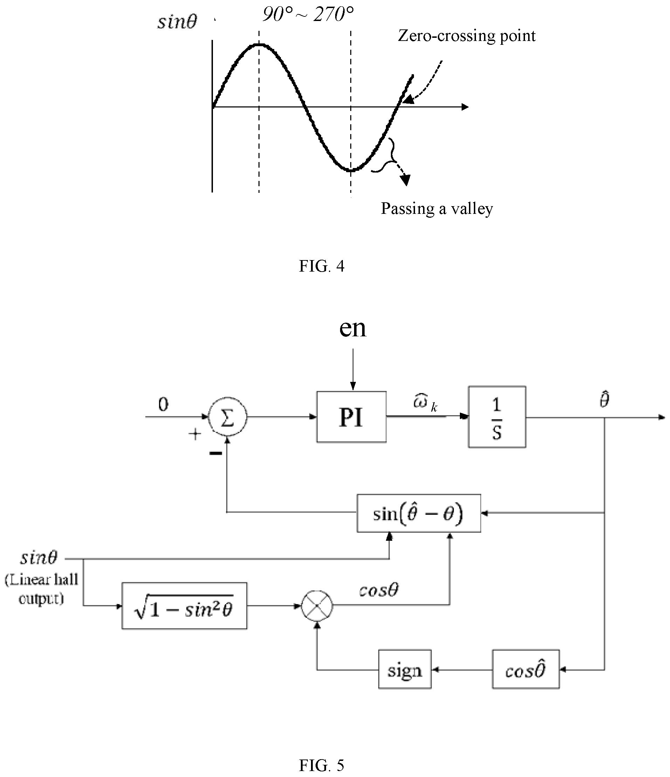

The error set value of the angle can be zero, which represents that a deviate between the estimated angle position and the actual angle posiiton of the rotor is zero degrees, and after the different operation (for example Σ module in FIG. 5) is performed between the error signal of the angle position and zero value, according to the characteristics of the sine function, $sin(\theta_k - \hat{\theta}_{k-1})$ can be obtained. When a value of $\hat{\theta} - \theta$ is small, for example approaches zero, $sin(\hat{\theta} - \theta) \approx \hat{\theta} - \theta$ is met, namely the effects of two respectively the estimation value $\hat{\theta}$ and the actual value $\theta$ are equivalent:

$$sin(\hat{\theta}_{k-1} - \theta_k) \approx \hat{\theta}_{k-1} - \theta_k$$

In some embodiments, the method 100 for detecting the angle position of the rotor of the electric motor further includes a step of drive-controlling the electric motor to start with a constant voltage frequency ratio V/F during a start-up initial period of the electric motor, the angle used in this period is an artificially given value of the angle changed according to certain rules, and an algorithm of the PLL module is not employed to obtain the estimation value of the angle position, this process is an open-loop control, a peak-to-peak value of the sinusoidal waveform can be identified in a open-loop driving period, and then a process of starting the PLL module is further supported. For example, in the V/F open-loop driving period, a rotation speed of the electric motor speeds up slowly from 0 rpm to 20 rpm, detail related parameters for example the magnitude of the waveform can be identified in this period, and a field-oriented control (FOC) closed-loop control is switched to after reaching 20 rpm, the electric motor is driven to reach a rotation speed value at a low temperature operating point, and the estimation value $\hat{\theta}$ of the angle outputted by the PLL module is used in the FOC period.

In some embodiments, during the V/F drive-controlling period, the sinusoidal waveform outputted by the hall sensor can be detected in real time, and its peak-to-peak value is identified, thus a peak value of the sinusoidal waveform and an offset value of the sinusoidal waveform can be obtained, and the normalization is performed on the sinusoidal waveform from the hall sensor to obtain a $sin\,\theta$ waveform with a value range from -1 to 1.

Moreover, a positive or negative sign of a slope of the sinusoidal waveform outputted from the hall sensor, namely the waveform in a rising/descending range, can also be identified in real time during the V/F drive-controlling period, and a control strategy can be a starting of the improved PLL module of an embodiment of the present disclosure during a rising range of the magnitude of the sinusoidal waveform (at this moment of the angle of the rotor is in a range from -90 degrees to 90 degrees), the PLL module can ensure the convergence and a stability of a whole system in this period, it is beneficial to improve an estimation accuracy of the angle position of the rotor by the improved phase locked loop structure provided by an embodiment of the present disclosure. Referring to FIG. 4, FIG. 4 is a diagram showing turning on the PLL strategy during a rising range of an embodiment of the present disclosure. Because the rising range is followed by the valley, the PLL module is started after passing through the valley at a certain angle, which is because that when the waveform of $sin\,\theta$ is in the valley, the magnitudes at different angles are close to each other, which does not facilitate an identification of the angles, thus the PLL module is started after passing through the valley and at a selected position for example $sin\,\theta > -1/2$, at the moment a starting of the PLL module can have sufficient time to cause the estimation value of the angle position of the rotor to converge to the actual angle of the rotor, causing the estimation value of the angle of the rotor outputted by the PLL module to be sufficiently close to the actual value of the angle of the rotor, and can further avoid a condition that the waveform near the valley is gentle and is disadvantageous for the identification of the angle, which facilitates a smoothly transition of the related vlaues of the parameters when the FOC control is switched to at a zero-crossing point. Then the V/F open-loop control can be switched to the FOC closed-loop control at the zero-crossing point of the rising range, and the FOC closed-loop control strategy can cause the electric motor to effectively work at a specified operating point, comparing to other methods for example a driving by a square wave, an effect of the FOC driving is better, harmonic contents are smaller, and the rotation speed of the electric motor and the output torque of the electric motor is steadier. Moreover, the FOC combined with the linear hall sensor are work at a low temperature environment to reduce a calibration requirement of the linear hall sensor.

In detail, a certain driving voltage and a certain angle of the rotor are outputted by the V/F drive-controlling, ensuring that the electric motor can be successfully started. When the single sinusoidal signal $sin\,\theta$ of the electric motor is within the rising range of the waveform and the magnitude reaches a fifth threshold T5, or is within the descending range of the waveform and the magnitude reaches a sixth threshold T6, the PLL module is started, where the fifth threshold T5 is a negative number, and the sixth threshold T6 is a positive value. In detail, T5 can be -1/2 of the peak value of $sin\,\theta$, and T6 can be 1/2 of the peak value of $sin\,\theta$, for example, T5 can be set to be -1/2, and T6 can be set to be 1/2, and when $\theta=$ -0.053rad/s (namely -30 degrees is reached) at the rising range after passing through the valley, a function of the PLL module is started. A required time from this time to the zero-crossing point 0 degrees is long, which is enough for the PLL processing to converge to the actual angle, the FOC can be directly switched to after the angle is determined to be converged when the rotor reaches the zero-crossing point 0 degrees, and a FOC periord is the closed-loop control period. The present embodiment employs the zero-crossing point of the range from -90 degrees to 90 degrees when the FOC closed-loop control is first switched to, and the zero-crossing point is no longer need to be used after the switching, namely the zero-crossing point is no longer used in an entire 360 degrees range.

In a preferred embodiment, a given initial value of the estimation value $\hat{\theta}$ of the angle position can be -30 degrees, namely 0.053rad/s. Because the function of the PLL is selected to be started when the waveform passes through the valley at a position of -30 degrees in the V/F open-loop driving period, thus a matched estimation value of the angle postion is directly given, which is beneficial to short the convergence time of the PLL processing. An initial angular velocity can be a corresponding value of the angular velocity when the electric motor is controlled by the V/F driving to a steafy rotation speed 20 rpm, this can ensure that an error between the estimated angular velocity and the actual angular velocity is made as small as possible. A data at the first beat when the FOC closed-loop control is switched to can use the estimation value of the angle position and the estimation value of the anguar velocity estimated by the PLL module.

It is noted that, the term "starting" of the PLL module refers to start to call the PLL function module, including the PLL module being enabled and the PLL module being disabled total two parts. The embodiment selects the range from -90 degrees to 90 degrees, namely starts the PLL function module when the waveform of the sinusoidal signal is at the rising range, and is not as a limit of the disclosure, in other embodiments, a starting of the PLL function module at a selection of a range from 90 degrees to 270 degrees, namely at the descending range of the waveform of the sinusoidal signal, is also possible, only a 180 degrees compensation angle needs to be added to this range. After the PLL module is started, whichever range of the angle is in later, the PLL module has been alway in a "starting" state, only is disabled in the peak sections and in the valley sections, and is enabled in other sections, thus to be repeatedly enabled/disabled.

In some embodiments, the method 100 for detecting the angle position of the rotor of the electric motor further includes outputting the estimation value $\hat{\theta}$ of the angle position outputted by the PLL module to the FOC module, for the FOC module to call to control the electric motor to work at a rotation speed value (for example 100 rpm) at the specified operting point. After the calculation of the PLL module, an accuracy of this estimation value $\hat{\theta}$ is high, and the actual value of the angle position of the rotor can be indefinitly closed to after the PLL processing is converged. Moreover, because only one linear hall sensor is employed to measure, and only a single path of signal $sin\,\theta$ is needed to generate, a high accuracy angle position of the rotor can be detected, and an angle of the rotor of the electric motor of a range from 0 degrees to 360 degrees is obtained, which does not increase a complexity of a software algorithms, and simultaneously decreases the cost of the product.

FIG. 3 is an examplary structure of a device 300 for detecting the angle position of the rotor of the electric motor according to another embodiment of the present disclosure. The device 300 includes a detection module 301, a peak and valley identification module 302, and an improved PLL module 303. The detection module 301 is configured to sense the position of the rotor by the hall sensor, output the voltage waveform signal, and perform the normalization processing on the voltage waveform signal to otain the single sinusoidal signal $sin\,\theta$. The peak and valley identification module 302 is configured to identify the peak sections and the valley sections of the single sinusoidal signal $sin\,\theta$, and convert the single sinusoidal signal $sin\,\theta$ into the square wave signal to enable or disable a proportional integral control module 3032 in the PLL module 303.

The improved PLL module 303 according to an embodiment of the present disclosure further includes a processing module 3031, a proportional integral control (PI) module 3032, a sign function module 3033, a difference operation module 3034, and an angle integration (I/S) module 3035. The processing module 3031 is configured to obtain the first cosine signal $\sqrt{1 - sin\,\theta^2}$ based on the single sinusoidal signal $sin\,\theta$, and obtain the cosine signal $cos\,\theta$ based

on the first cosine signal $\sqrt{1 - sin\,\theta^2}$ and the positive or negative sign of the magnitude of the waveform of the second cosine signal $cos\,\hat{\theta}$. The proportional integral control module 3032 is configured to estimate the estimation value of the angular velocity signal in real time $\hat{\omega}_k = K_p * sin(\theta_k - \theta_{k-1}) + K_i * T_s * \int sin(\theta_k - \hat{\theta}_{k-1})$ during being enable, and estimate the angular velocity signal $\hat{\omega}_k$ of the rotor configured for obtaining the estimation value $\hat{\theta}$ of the angle position, where, $K_p$ is the proportional gain, $K_i$ is the integral gain, and $T_s$ is the sampled time. Moreover, the angle integration (I/S) module 3035 is coupled to the proportional integral control module 3032, to obtain the estimation value $\hat{\theta}$ of the angle position according to the estimated angular velocity signal $\hat{\omega}_k$ of the rotor. In the embodiment as shown in FIG. 3, during the PLL module 303 being disable, I/S module 3035 can continue to maintain the working to calculate the estimation value $\hat{\theta}$ of the angle position. For example, during the PLL module 303 being disable, the proportional integral control module 3032 is disabled, but the I/S module 3035 continues to maintain the operation, and can calculate to obtain a corresponding estimation value of the angle position $\hat{\theta}_k = T_s * \hat{\omega}_k + \theta_{k-1}$, based on the estimation value $\hat{\omega}_{k,last}$ of the angular velocity signal at the moment before the proportional integral control module 3032 is disabled. Where the estimation value $\hat{\omega}_{k,last}$ of the angular velocity signal is used to be the estimation value $\hat{\omega}_k$ of the angular velocity signal during being disable to perform the calculation.

The sign function module 3033 is configured to obtain the second cosine signal $cos\,\hat{\theta}$ and obtain the positive or negative sign of the magnitude of the waveform of the second cosine signal $cos\,\hat{\theta}$, based on the estimation value $\hat{\theta}$ of the angle position. The difference operation module 3034 is configured to perform the difference operation between the error signal $\theta_{err}$ of the angle position and the error set value of the angle to obtain $sin(\theta_k - \hat{\theta}_{k-1})$, and when the value of $\hat{\theta} - \theta$ is small, $sin(\hat{\theta} - \theta) \approx \hat{\theta} - \theta$ is met, namely the effects of two respectively the estimation value $\hat{\theta}$ and the actual value $\theta$ are equivalent, thus when the PLL module judges that $sin(\theta_k - \theta_{k-1})$ converges to $\theta_k - \theta_{k-1}$, the estimation value $\hat{\theta}$ of the angle position is outputted to be the actual value $\theta$ of the angle position. Otherwise, the PLL modue 303 is configured to obtain an error signal $\theta_{err}$ of the angle position configured to estimate the angular velocity signal $\hat{\omega}_k$, based on the single sinusoidal signal $sin\,\theta$, the cosine signal $cos\,\theta$, and the estimation value $\hat{\theta}$ of the angle position, which can be executed by the processing module 3031.

In some embodiments, the peak and valley identification module 302 performs a real-time identification on the value of the single sinusoidal signal $sin\,\theta$ from a normalization, outputs the low level when the waveform is detected to be about to near the peak and is greater than a set magnitude threshold T1 configured for disabling the proportional integral control module, or when the waveform is detected to be about to near the valley and less than a set magnitude threshold T2 configured for disabling the the proportional integral control module, and disables the proportional integral control module. When the peak is passed and a real-time value of $sin\,\theta$ from the normalization is less than the set magnitude threshold T1 configured for disabling the proportional integral control module, or when the valley is passed and the real-time value of $sin\,\theta$ from the normalization is greater than the set magnitude threshold T2 configured for disabling the proportional integral control module, a high level is outputted, and the proportional integral control module is enabled. During cutting out peak sections and valley sections, a threshold hysteresis loop strategy is employed to set the threshold, thus T1 and T2 respectively includes two detail thresholds, T11 and T12, and T21 and T22.

For example, when the peak and valley identification module 302 detects that the single sinusoidal signal *sin θ* is the peak, the waveform of each peak section from the front of the peak where the magnitude is greater than the first threshold T11 to the back of the peak where the magnitude is greater than the second threshold T12 is converted into the low level; when the single sinusoidal signal *sin θ* is detected to be the valley, the waveform of each valley section from the front of the valley where the magnitude is less than the third threshold T21 to the back of the valley where the magnitude is less than the fourth threshold T22 is converted into the low level; and the waveforms at the other sections of the single sinusoidal signal *sin θ* are both coverted into the high level, thus the sinusoidal signal is converted into the square wave signal to control the proportional integral control module 3032 of the PLL module 303 to be enabled or to be disabled, and this is cyclically executed. The first threshold T11 and the second threshold T12 can be set to be positive numbers, and the third threshold T21 and the fourth threshold T22 can be set to be negative numbers. For example, T11 can be set to be 0.86 of the peak value of the single sinusoidal signal *sin θ,* T12 can be set to be 0.8 of the peak value of the single sinusoidal signal *sin θ*, T21 can be set to be -0.86 of the peak value of the single sinusoidal signal *sin θ*, and T22 can be set to be -0.8 of the peak value of the single sinusoidal signal *sin θ*. The set thresholds of the embodiment are not as a limit of the disclosure, enlarging or reducing the peak sections and the valley sections to be cut out by changing the thresholds are also feasible.

The square wave signal converted by the peak and valley identification module 302 can be outputted to the PI module 3032, and the hight level and the low level from it can be used to enable and disable the PI module 3032, for example disabled the proportional integral control module 3032, but not participate in the operation itself performed in the PI module 3032. When the square wave signal is the high level, the proportional integral control module 3032 is enabled; and when the square wave signal is the low level, the proportional integral control module 3032 is disabled.

Moreover, the angle integration (I/S) module 3035 can be coupled to the proportional integral control module 3032, to obtain the estimation value $\hat{\theta}$ of the angle position according to the estimated angular velocity signal $\hat{\omega}_k$ of the rotor. For example, during the proportional integral control module 3032 being disable, I/S module 3035 can continue to maintain the operation, namely can calculate to obtain a corresponding estimation value of the angle position $\hat{\theta}_k = T_s * \hat{\omega}_k + \hat{\theta}_{k-1}$ based on the estimation value $\hat{\omega}_{k,last}$ of the angular velocity signal at the moment before the proportional integral control module 3032 is disabled, where the estimation value $\hat{\omega}_{k,last}$ of the angular velocity signal is used to be the estimation value $\hat{\omega}_k$ of the angular velocity signal during being disable to perform the calculation.

The proportional integral control module 3032 is enabled or disabled according to the square wave signal, and estimates the estimation value of the angular velocity signal in real time $\hat{\omega}_k = K_p * sin(\theta_k - \hat{\theta}_{k-1}) + K_i * T_s * \int sin(\theta_k - \hat{\theta}_{k-1})$ during it being enable, and is configured to obtain the estimation value $\hat{\theta}$ of the angle position according to the angular velocity signal $\hat{\omega}_k$ of the rotor, due to the nature of an electric motor system, after the PI session, an outputted physical quantity is the anglular velocity signal of the electric motor, namely $\hat{\omega}_k$. During the proportional integral control module 3032 being enable, the estimation value of the angular velocity signal is estimated by the proportional integral control PI module 3032 in real time:

$$\widehat{\omega}_k = K_p * sin(\theta_k - \widehat{\theta}_{k-1}) + K_i * T_s * \int sin(\theta_k - \widehat{\theta}_{k-1})$$

Where, $K_p$ is the proportional gain, $K_i$ is the integral gain, and $T_s$ is the sampled time.

During the proportional integral control module 3032 being disable, an estimation value $\hat{\omega}_{k,last}$ of the angular velocity signal at the moment before being disabled is used to be the estimation value $\hat{\omega}_k$ of the angular velocity signal during being disable. Based on the estimation value $\hat{\omega}_k$ of the angular velocity signal, the estimation value of the angle position can be obtained by a discretization formulas corresponding to the I/S module 3035:

$$\widehat{\theta}_k = T_s * \widehat{\omega}_k + \widehat{\theta}_{k-1}$$

The sign function module 3033 obtains the second cosine signal *cos $\hat{\theta}$* and obtains the positive or negative sign of the magnitude of the waveform of the second cosine signal *cos $\hat{\theta}$,* based on the estimation value $\hat{\theta}$. The processing module 3031 obtains the first cosine signal $\sqrt{1 - sin\,\theta^2}$ based on the single sinusoidal signal *sin θ,* and obtains the cosine signal *cos θ* based on the first cosine signal $\sqrt{1 - sin\,\theta^2}$ and the positive or negative sign of the magnitude of the waveform of the second cosine signal *cos $\hat{\theta}$*. The processing module 3031 can further obtain an error signal $\theta_{err}$ of the angle position configured to estimate the angular velocity signal $\hat{\omega}_k$, based on the single sinusoidal signal *sin θ*, the cosine signal *cos θ*, and the estimation value $\hat{\theta}$ of the angle position. In some embodiments, the error signal $\theta_{err}$ of the angle position corresponds to *sin($\hat{\theta} - \theta$)*, and the error signal $\theta_{err}$ of the angle position can be calculated by the following formula:

$$\theta_{err} \approx sin\left(\hat{\theta}_{k-1} - \theta_k\right) = sin\,\hat{\theta}_{k-1}\,cos\,\theta_k - cos\,\hat{\theta}_{k-1}\,sin\,\theta_k$$

The difference operation module 3034 can be achieved by a Σ module in the FIG. 4, and can perform the difference operation between the error signal $\theta_{err}$ of the angle position and the error set value of the angle to obtain $sin(\theta_k - \hat{\theta}_{k-1})$. When the PLL module 303 judges that $sin(\theta_k - \theta_{k-1})$ converges to $\theta_k - \theta_{k-1}$, the estimation value $\hat{\theta}$ of the angle position is outputted to be the actual value $\theta$ of the angle position of the rotor.

In some embodiments, the device 300 for detecting the angle position of the rotor of the electric motor can further include a V/F driving module 304, which is configured to output the certain driving voltage and the certain angle of the rotor, and start the electric motor. In some embodiments, the V/F driving module 304 can detect the sinusoidal waveform outputted by the hall sensor in real time, and identify its peak-to-peak value, thus the peak value of the sinusoidal waveform and the offset value of the sinusoidal waveform signal can be obtained, and the normalization is performed on the sinusoidal waveform from the hall sensor to obtain the $sin\,\theta$ waveform with a value range from -1 to 1. Moreover, the V/F driving module 304 can identify the positive or negative sign of the slope of the sinusoidal waveform outputted from the hall sensor in real time, namely the waveform being in the rising/descending range, the control strategy can be a starting of the PLL module during the rising range of the magnitude of the sinusoidal waveform (at this moment of the angle of the rotor is in a range from -90 degrees to 90 degrees), it is beneficial to improve the detection accuracy of the angle position of the rotor by the improved phase locked loop structure provided by an embodiment of the present disclosure.

In detail, when the single sinusoidal signal $sin\,\theta$ of the electric motor is within the rising range of the waveform and the magnitude reaches the fifth threshold T5, or is within the descending range of the waveform and the magnitude reaches the sixth threshold T6, the PLL module 303 is started. Where the fifth threshold T5 is the negative number, and the sixth threshold is the positive value. In detail, T5 can be -1/2 of the peak value of $sin\,\theta$, and T6 can be 1/2 of the peak value of $sin\,\theta$, for example, T5 can be set to be -1/2, and T6 can be set to be 1/2, and when θ= -0.053rad/s (namely -30 degrees is reached) at the rising range after passing through the valley, a function of the PLL module is started. Because a required time from this time to the 0 degrees is long, which is enough for the PLL processing to converge to the actual angle, and the closed-loop controlled field-oriented control FOC module 305 can be directly switched to after the angle is determined to be converged when the rotor reaches the 0 degrees, where the FOC periord is the closed-loop control period, a data at the first beat when the FOC closed loop control is switched to can use the estimation value of the angle position and the estimation value of the angular velocity estimated by the PLL module.

The initial angular velocity can be the corresponding value of the angular velocity when the electric motor is controlled by the V/F driving to the steady rotation speed 20 rpm, this can ensure that the error between the estimated angular velocity and the actual angular velocity is made as small as possible. In the embodiment, 20 rpm is only used as a transitional intermediate speed, to control the electric motor to be successfully started during the V/F driving, and the low speed operating point at which the electric motor is controlled to work by the FOC module 305 is the rotation speed value (for example 100 rpm) at the operating point of an electric oil pump.

In some embodiments, the device 300 for detecting the angle position of the rotor of the electric motor can further include a field-oriented control FOC module 305, which is configured to call the estimation value $\hat{\theta}$ of the angle position outputted by the PLL module 303, and drive the electric motor to work at the rotation speed value of the specified operating point, for example 100 rpm. The field-oriented control FOC module 305 employs the FOC closed-loop control strategy, which can cause the electric motor to effectively work at the specified operating point, comparing to other methods for example the driving by the square wave, the effect of the FOC closed-loop control strategy is better, the harmonic contents are smaller, and the rotation speed of the electric motor and the output torque of the electric motor is steadier. Moreover, the FOC module 305 combined with the linear hall sensor are work at the low temperature environment to reduce the calibration requirement of the linear hall sensor.

The method and the device for detecting the angle position of the rotor of the electric motor are inexpensive, are simple and convenient operations, have a high estimation accuracy, and improve a reliability of the system; and can be widely used in a control system of the three-phases electric motor, does not need additional hardware outlay, and can obtain a satifsying control performance.

FIG. 5 is a diagram showing a core module of the improved phase locked loop loop according to an embodiment of the present disclosure. The similar element and similar parameter included in the FIG. 1 and the FIG. 3 can be applied in FIG. 5, and are identified by the reference numerals and parametric expression which are the same as in the FIG. 1 and the FIG. 3, thus for the sake of brevity, the description thereof will not be repeated here.

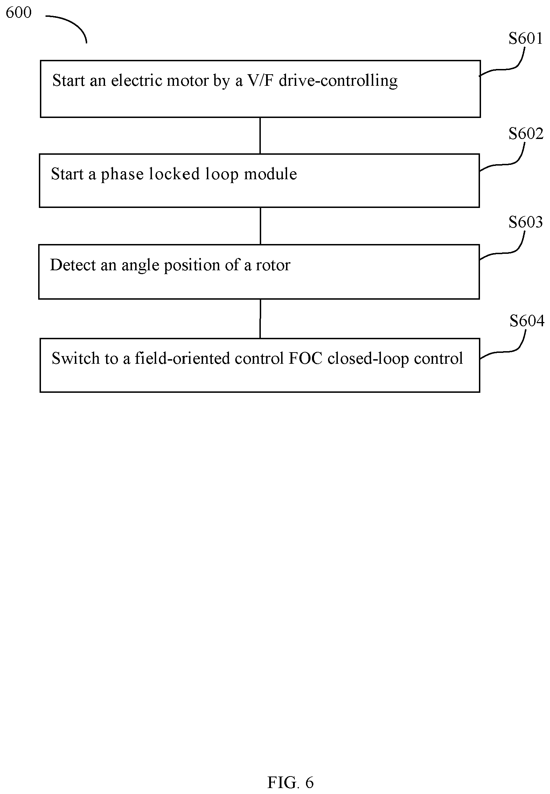

FIG. 6 is a structure view showing a cold start method 600 of the electric motor according to another embodiment of the present disclosure. The electric motor of the oil pump have a low temperature requirement, for example starting at a temperature less than -20°C. The cold start method 500 includes:

> S601: outputting the certain driving voltage and the certain angle of the rotor by the V/F drive-controlling, and starting the electric motor.

S602: starting the PLL module when the single sinusoidal signal $sin\,\theta$ outputted by the hall sensor during sensing the position of the rotor of the electric motor is within the rising range of the waveform and the magnitude reaches the fifth threshold T5, or when $sin\,\theta$ is within the descending range of the waveform and the magnitude reaches the sixth threshold T6, where the fifth threshold T5 is the negative number, and the sixth threshold is the positive value, in detail, T5 can be -1/2 of the peak value of $sin\,\theta$, and T6 can be 1/2 of the peak value of $sin\,\theta$. For example the fifth threshold can be -1/2, and the sixth threshold can be 1/2.

S603: detecting the angle position of the rotor, according to the method for detecting the angle position of the rotor of the electric motor of the embodiment of FIG. 1.

S604: switching to the field-oriented control FOC closed-loop control, when the electric motor reaches a predetermined rotation speed value. Where the FOC closed-loop control calls the estimation value of the angle position of the rotor outputted by the PLL module, and drives the electric motor to reach the rotation speed value at a predetermined operating point.

A detail execution processing involed in each step of the cold start method of FIG. 6 can refer to the descriptions in the embodiments of the previous text, and for the sake of brevity, the description thereof will not be repeated here.

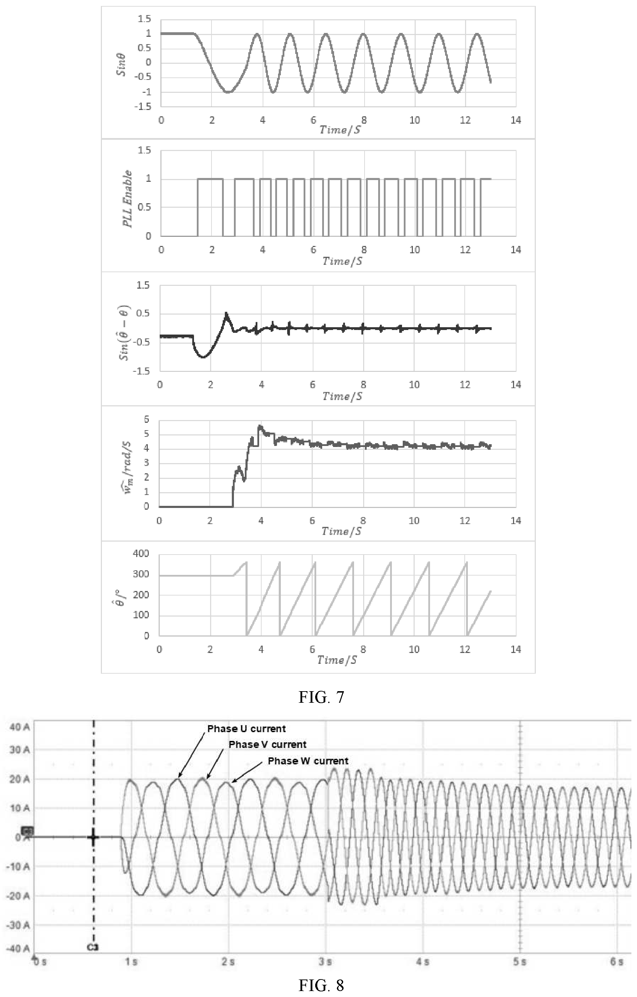

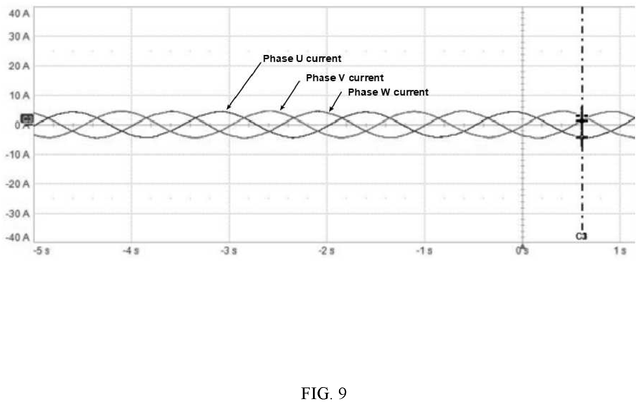

FIG. 7 is results of test runs of each parameter by the method for detecting the angle position of an electric rotor according to an embodiment of the present disclosure. FIG. 7 shows a diagram of each prameter of the improved PLL module when 40 rpm is turned on to. FIG. 8 is a result of a test run of a three-phases current of the electric motor according to an embodiment of the present disclosure. FIG. 8 shows a diagram of a U/V/W phase current on the windings of the electric motor when 40 rpm is turned on to, where a period from one second to three seconds is a V/F open-loop drive-controlling phase, causing the rotation speed of the electric motor to speed up slowly from 0 rpm to 20 rpm, and the related detail parameters for example the magnitude of the waveform can be identified in this period, which is referred in the foregoing embodiment. It is noted that, 40 rpm in the FIG. 7 to FIG. 8 is only configured to show that the disclosure can support a steady running at a rotation speed as low as 40 rpm, but this rotation speed is not served as a limit of the specified operating point. FIG. 9 is a result of a test run of a three-phases current of an electric motor according to another embodiment of the present disclosure. FIG. 9 shows a diagram of the U/V/W phase current on the windings of the electric motor when 10 rpm is turned on to. Because a drive motor is the electric motor of a gear oil pump, a torque ripple of it is larger at low speeds, which is not beneficial to the steady of the speed, and it is more difficult to maintain a stability of the electric motor of the oil pump as the rotation speed is slow. It can be seen from FIG. 9, even in a low rotation speed such as 10 rpm, by the solution proposed in the embodiment of the present disclosure, the electric motor of the oil pump can still work at a steady rotation speed. The test data of FIG. 7 to FIG. 9 is the actual detection result by employing the solution of the present disclosure to run the electric motor, it can be seen that the present disclosure achieves a high accuracy detection of the angle, and provides the positive assurance for the efficient and stable control of the system.

Those skilled in the art can clearly understand that, for the convenience and conciseness of the description, for the specific operation processings of the systems, devices, and units described above, reference can be made to the corresponding processings in the foregoing method embodiments, and details thereof will be omitted herein.

In the embodiments of the present disclosure, it can be appreciated that the disclosed systems, devices, and methods may be implemented in other ways. For example, various steps in each flowchart may be executed in an order other than as presented, the numbering of the various steps in the method embodiments described above are merely illustrative, and do not limit an execution sequence of the steps. Moreover, the device embodiments described above are merely illustrative, for example, the divisions of the modules are only divisions based on logical functions, and there may be other divisions in actual implementations, for example, more than one module or component may be combined or integrated into another system, or some features can be omitted, or not executed. Otherwise, the mutual coupling or direct coupling or communication connections illustrated or discussed above may be indirect coupling or communication connections via an interface, a device, or a module, and may be in electrical, mechanical, or other forms.

The modules described as separate components may or may not be physically separated, the component displayed as a module may be or may not be a physical module, that is, it may be located at one place, or it may be distributed to multiple network units. Some or all of the mudules may be selected according to actual requirements to achieve the purpose of the schemes of the embodiments.

In addition, various functional modules in various embodiments of the present disclosure may be integrated into one processing unit, various modules may exist physically alone, or two or more modules may be integrated into one module. The integrated module may be implemented in a form of hardware or a software functional module.

When the integrated module is implemented in the form of the software functional unit and sold or used as an independent product, the integrated module may be stored in a computer-readable storage medium. Based on such an understanding, the technical solutions in embodiments of this application essentially, or the part contributing to conventional technologies, or all or some of the technical solutions may be implemented in a form of a software product, the computer software product is stored in a storage medium, and includes several instructions for instructing a computer device (which may be a personal computer, a server, a network device, or the like) to perform all or some of the steps in the methods described in the embodiments of the present application. The foregoing storage medium includes any medium that can store program code, such as a U disk, a removable hard disk, a read-only memory (ROM), a random access storage (RAM), a magnetic disk, or an optical disc.

The above description of the disclosed embodiments enables those skilled in the art to realize or use the present invention. Many modifications to these embodiments will be apparent to those skilled in the art. The general principle defined herein can be realized in other embodiments without departing from the spirit or scope of the present disclosure. Therefore, the present disclosure will not be limited to these embodiments shown herein, but will conform to the widest scope consistent with the principle and novel features disclosed herein.

## Claims

1. A method for detecting an angle position of a rotor of an electric motor, comprising:

   sensing a position of the rotor by a hall sensor, outputting a voltage waveform signal, and performing a normalization processing on the voltage waveform signal to obtain a single sinusoidal signal $sin\,\theta$;

   obtaining a first cosine signal $\sqrt{1 - sin\,\theta^2}$ according to the single sinusoidal signal $sin\,\theta$;

   converting the signal sinusoidal signal $sin\,\theta$ into a square wave signal to control a proportional integral control module of a phase locked loop module to be enabled or to be disabled, by identifying a pluralty of peak sections and a plurality of valley sections of the single sinusoidal signal $sin\,\theta$;

   estimating, during the proportional integral control module being enable, an estimation value of an angular velocity signal $\hat{\omega}_k = K_p * sin(\theta_k - \theta_{k-1}) + K_i * T_s * \int sin(\theta_k - \hat{\theta}_{k-1})$ by the proportional integral control module in real time, where, $K_p$ is a proportional gain, $K_i$ is an integral gain, and $T_s$ is a sampled time;

   obtaining an estimation value $\hat{\theta}$ of the angle postion according to the angular velocity signal $\hat{\omega}_k$ of the rotor;

   obtaining a second cosine signal $cos\,\hat{\theta}$ and obtaining a positive or negative sign of a magnitude of a waveform of the second cosine signal $cos\,\hat{\theta}$, based on the estimation value $\hat{\theta}$ of the angle position;

   obtaining a cosine signal $cos\,\theta$, based on the first cosine signal $\sqrt{1 - sin\,\theta^2}$ and the positive or negative sign;

   obtaining an error signal $\theta_{err}$ of the angle position configured for the proportional integral control module to estimate the angular velocity signal $\hat{\omega}_k$, based on the single sinusoidal signal $sin\,\theta$, the cosine signal $cos\,\theta$, and the estimation value $\hat{\theta}$ of the angle position; and

   performing a difference operation between the error signal $\theta_{err}$ of the angle position and an error set value of an angle to obtain $sin(\theta_k - \hat{\theta}_{k-1})$, and outputting the estimation value $\hat{\theta}$ of the angle position to be an actual value $\theta$ of the angle position when the phase locked loop module judges that $sin(\theta_k - \theta_{k-1})$ converges to $\theta_k - \hat{\theta}_{k-1}$.

2. The method according to claim 1, wherein,
   the converting the signal sinusoidal signal $sin\,\theta$ to the square wave signal comprises:

   converting, when the single sinusoidal signal $sin\,\theta$ is detected to be a peak, a waveform of each peak section of the plurality of peak sections from a front of the peak where the magnitude is greater than a first threshold T11 to a back of the peak where the magnitude is greater than a second threshold T12 into a low level;

   converting, when the single sinusoidal signal $sin\,\theta$ is detected to be a valley, a waveform of each valley section of the plurality of valley sections from a front of the valley where the magnitude is less than a third threshold T21 to a back of the valley where the magnitude is less than a fourth threshold T22 into the low level; and

   converting waveforms at the other sections of the signal sinusoidal signal $sin\,\theta$ into a high level;

   where, the first threshold T11 and the second threshold T12 are positive numbers, and the third threshold T21 and the fourth threshold T22 are negative numbers.

3. The method according to claim 2, wherein,
   the first threshold T11 is 0.86 of a peak value of the single sinusoidal signal $sin\,\theta$, the second threshold T12 is 0.8 of the peak value of the single sinusoidal signal $sin\,\theta$, the third threshold T21 is -0.86 of the peak value of the single sinusoidal signal $sin\,\theta$, and the fourth threshold T22 is -0.8 of the peak value of the single sinusoidal signal $sin\,\theta$.

4. The method according to any one of claims 1 to 3, wherein,
   the proportional integral control module is controlled to be enabled or to be disabled, according to the square wave signal comprising:

when the square wave signal is a high level, the proportional integral control module is enabled; and
when the square wave signal is a low level, the proportional integral control module is disabled.

5. The method according to claim 1 , wherein,
the obtaining the estimation value $\hat{\theta}$ of the angle postion comprises:
using, during the proportional integral control module being disable, an estimate value $\hat{\omega}_{k,last}$ of the angular velocity signal at the moment before being disabled to be the estamition value $\hat{\omega}_k$ of the angular velocity signal during being disable.

6. The method according to claim 1 , wherein,
based on the estimation value $\hat{\omega}_k$ of the angular velocity signal, the estimation value $\theta_k = T_s * \hat{\omega}_k + \hat{\theta}_{k-1}$ of the angle postion is obtained.

7. The method according to claim 1, further comprising:

   outputting a certain driving voltage and a certain angle of the rotor by a V/F drive-controlling, and starting the electric motor;
   starting the phase locked loop module, when the single sinusoidal signal $sin\,\theta$ of the electric motor is within a rising rangeof the waveform and the magnitude reaches a fifth threshold, or is within a descending range of the waveform and the magnitude reaches a sixth threshold;
   where the fifth threshold is a negative number, and the sixth threshold is a positive number.

8. The method according to claim 7 , wherein:
the fifth threshold is -1/2, and the sixth threshold is 1/2.

9. The method according to claim 1, further comprising:
outputting the estimation value $\hat{\theta}$ of the angle position to a field-oriented control FOC module.

10. The method according to claim 1 , wherein:
the error signal $\theta_{err}(k)$ of the angle position corresponds to $sin(\hat{\theta}_{k-1} - \theta_k)$.

11. A device for detecting an angle position of a rotor of an electric motor, comprising:

   a detection module configured to sense a position of the rotor by a hall sensor, output a voltage waveform signal, and perform a normalization processing on the voltage waveform signal to obtain a single sinusoidal signal $sin\,\theta$;
   a peak and valley identification module configured to identify a plurality of peak sections and a plurality of valley sections of the single sinusoidal signal $sin\,\theta$, and convert the signal sinusoidal signal $sin\,\theta$ into a square wave signal to enable or disable a proportional integral control module of a phase locked loop module; and
   the phase locked loop module comprising:

   a processing module configured to obtain a first cosine signal $\sqrt{1 - sin\,\theta^2}$ according to the single

   sinusoidal signal $sin\,\theta$, and obtain a cosine signal $cos\,\theta$ based on the first cosine signal $\sqrt{1 - sin\,\theta^2}$ and a positive or negative sign of a magnitude of a waveform of a second cosine signal $cos\,\hat{\theta}$;
   the proportional integral control module configured to estimate, during being enable, an estimation value of an angular velocity signal $\hat{\omega}_k = K_p * sin(\theta_k - \theta_{k-1}) + K_i * T_s * \int sin(\theta_k - \hat{\theta}_{k-1})$ in real time, and obtain an estimation value $\hat{\theta}$ of the angle postion according to the angular velocity signal $\hat{\omega}_k$ of the rotor, where $K_p$ is a proportional gain, $K_i$ is an integral gain, and $T_s$ is a sampled time;
   a sign function module configured to obtain the second cosine signal $cos\,\hat{\theta}$ and obtain the positive or negative sign of the magnitude of the waveform of the second cosine signal $cos\,\hat{\theta}$, based on the estimation value $\hat{\theta}$; and
   a difference operation module configured to perform a difference operation between an error signal $\theta_{err}$ of the angle position and an error set value of an angle to obtain $sin(\theta_k - \hat{\theta}_{k-1})$, and output the estimation value $\hat{\theta}$ of the angle position to be an actual value $\theta$ of the angle position when the phase locked loop module judges that $sin(\theta_k - \hat{\theta}_{k-1})$ converges to $\theta_k - \hat{\theta}_{k-1}$;
   where, the phase locked loop module further obtains an error signal $\theta_{err}$ of the angle position configured to estimate the angular velocity signal $\hat{\omega}_k$, based on the single sinusoidal signal $sin\,\theta$, the cosine signal $cos\,\theta$, and the estimation value $\hat{\theta}$ of the angle position.

12. The device according to claim 1, wherein the peak and valley identification module:

   converts, when the single sinusoidal signal *sin θ* is detected to be a peak, a waveform of each peak section of the plurality peak sections from a front of the peak where the magnitude is greater than a first threshold T11 to a back of the peak where the magnitude is greater than a second threshold T12 into a low level;
   converts, when the single sinusoidal signal *sin θ* is detected to be a valley, a waveform of each valley section of the plurality of valley sections from a front of the valley where the magnitude is less than a third threshold T21 to a back of the valley where the magnitude is less than a fourth threshold T22 into the low level; and
   converts waveforms at the other sections of the signal sinusoidal signal *sin θ* into a high level;
   where, the first threshold T11 and the second threshold T12 are positive numbers, and the third threshold T21 and the fourth threshold T22 are negative numbers.

13. The device according to claim 12, wherein the first threshold T11 is 0.86 of a peak value of the single sinusoidal signal *sin θ*, the second threshold T12 is 0.8 of the peak value of the single sinusoidal signal *sin θ*, the third threshold T21 is -0.86 of the peak value of the single sinusoidal signal *sin θ*, and the fourth threshold T22 is -0.8 of the peak value of the single sinusoidal signal *sin θ*.

14. The device according to any one of claims 11 to 13, wherein the proportional integral control module is enabled when the square wave signal is a high level; and the proportional integral control module is disabled when the square wave signal is a low level.

15. The device according to claim 11, wherein during the proportional integral control module being disable, an estimate value $\hat{\omega}_{k,last}$ of the angular velocity signal at the moment before being disabled is used to be the estamition value $\hat{\omega}_k$ of the angular velocity signal during being disable.

16. The device according to claim 11, wherein based on the estimation value $\hat{\omega}_k$ of the angular velocity signal, the estimation value $\hat{\theta}_k = T_s * \hat{\omega}_k + \hat{\theta}_{k-1}$ of the angle postion is obtained.

17. The device according to claim 11, further comprising:

   a V/F driving module configured to output a certain driving voltage and a certain angle of the rotor, start the electric motor, and start the phase locked loop module when the single sinusoidal signal *sin θ* of the electric motor is within a rising range of the waveform and the magnitude reaches a fifth threshold, or is within a descending range of the waveform and the magnitude reaches a sixth threshold;
   where the fifth threshold is a negative number, and the sixth threshold is a positive number.

18. The device according to claim 17, wherein the fifth threshold is -1/2, and the sixth threshold is 1/2.

19. The device according to claim 11, further comprising:
   a field-oriented control FOC module configured to call the estimation value $\hat{\theta}$ of the angle position outputted by the phase locked loop module, and drive the electic motor to work at a rotation speed value of a specified operting point.

20. The device according to claim 11, wherein the error signal $\theta_{err}(k)$ of the angle position corresponds to $sin(\hat{\theta}_{k-1} - \theta_k)$.

21. A cold start method of an electric motor, comprising:

   outputting a certain driving voltage and a certain angle of a rotor by a V/F driving controlling, and starting the electric motor;
   starting a phase locked loop module when the single sinusoidal signal *sin θ* outputted by a hall sensor during sensing a position of the rotor of the electric motor is within a rising range of a waveform and a magnitude reaches a fifth threshold, or is within a descending range of the waveform and the magnitude reaches a sixth threshold, where the fifth threshold is a negative number, and the sixth threshold is a positive number;
   detecting an angle postion of the rotor, according to a method for detecting an angle position of the rotor of the electric motor of any one of claims 1 to 10; and
   switching to a field-oriented control FOC closed-loop control, when the electric motor reaches a predetermined rotation speed value;
   where the field-oriented control FOC closed-loop control calls an estimation value of the angle postion, and drives the electric motor to reach a rotation speed value at a predetermined operating point.

**22.** The method according to claim 20, wherein the fifth threshold is -1/2, and the sixth threshold is 1/2.

100

S102

Sense a position of a rotor by a hall sensor, output a voltage waveform signal, and perform a normalization processing on the voltage waveform signal to obtain a single sinusoidal signal

S104

Obtain a first cosine signal based on the single sinusoidal signal

S106

Convert the single sinusoidal signal into a square wave signal to control a phase locked loop module, by identifying peak sections and valley sections of the single sinusoidal signal

S108

Estimate an angular velocity signal of the rotor by a phase locked loop module to obtain an estimation value of an angle position

S110

Obtain a second cosine signal and obtain a positive or negative sign of a magnitude of a waveform of the second cosine signal, based on the estimation value of the angle position

S112

Obtain a cosine signal based on the first cosine signal and the positive or negative sign of the magnitude of the waveform of the second cosine signal

S114

Obtain an error signal of the angle position configured for the phase locked loop module to estimate the angular velocity signal based on the single sinusoidal signal, the cosine signal, and the estimation value of the angle position

S116

Perform a difference operation between the error signal of the angle position and an error set value of an angle, and output the estimation value of the angle position to be an actual value of the angle position when the phase locked loop module judges that a result of the difference operation converges

FIG. 1

FIG. 2

FIG. 3

FIG. 4

FIG. 5

600

S601

Start an electric motor by a V/F drive-controlling

S602

Start a phase locked loop module

S603

Detect an angle position of a rotor

S604

Switch to a field-oriented control FOC closed-loop control

FIG. 6

FIG. 7

FIG. 8

FIG. 9

## INTERNATIONAL SEARCH REPORT

| | International application No. |
|---|---|
| | **PCT/CN2023/117324** |

| A. | CLASSIFICATION OF SUBJECT MATTER |
|---|---|

H02P21/18(2016.01)i

According to International Patent Classification (IPC) or to both national classification and IPC

| B. | FIELDS SEARCHED |
|---|---|

Minimum documentation searched (classification system followed by classification symbols)

IPC: H02P

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 电机, 转子, 角, 位置, 0, 正弦, 余弦, 正负, motor, rotor, angle, position, sine, cosine, wave, sign

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 114640276 A (WEIFU HIGH-TECHNOLOGY GROUP CO., LTD.) 17 June 2022 (2022-06-17)<br>description, paragraphs 48-107, and figures 1-7 | 1-22 |
| A | CN 108900130 A (GREE ELECTRIC APPLIANCES,INC. OF ZHUHAI) 27 November 2018 (2018-11-27)<br>entire document | 1-22 |
| A | CN 112152542 A (SHENZHEN ZHAOWEI MACHINERY & ELECTRONICS CO., LTD.) 29 December 2020 (2020-12-29)<br>entire document | 1-22 |
| A | CN 114584027 A (HARBIN UNIVERSITY OF SCIENCE AND TECHNOLOGY) 03 June 2022 (2022-06-03)<br>entire document | 1-22 |
| A | US 2005248306 A1 (AISIN SEIKI KABUSHIKI KAISHA) 10 November 2005 (2005-11-10)<br>entire document | 1-22 |
| A | KR 100478978 B1 (DARIM SYSTEM CO., LTD.) 28 March 2005 (2005-03-28)<br>entire document | 1-22 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **06 May 2024** | **15 May 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/117324**

| Patent document cited in search report | | | Publication date (day/month/year) | Patent family member(s) | | | Publication date (day/month/year) |
|---|---|---|---|---|---|---|---|
| CN | 114640276 | A | 17 June 2022 | None | | | |
| CN | 108900130 | A | 27 November 2018 | CN | 108900130 | B | 07 January 2020 |
| CN | 112152542 | A | 29 December 2020 | CN | 112152542 | B | 19 April 2022 |
| CN | 114584027 | A | 03 June 2022 | None | | | |
| US | 2005248306 | A1 | 10 November 2005 | US | 7714529 | B2 | 11 May 2010 |
| | | | | GB | 0410037 | D0 | 09 June 2004 |
| | | | | GB | 2413905 | A | 09 November 2005 |
| | | | | GB | 2413905 | B | 03 May 2006 |
| | | | | JP | 2005323490 | A | 17 November 2005 |
| KR | 100478978 | B1 | 28 March 2005 | None | | | |

Form PCT/ISA/210 (patent family annex) (July 2022)